(19) Europäisches Patentamt
European Patent Office
Office européen des brevets

(11) **EP 4 723 072 A1**

(12) **EUROPEAN PATENT APPLICATION**

(43) Date of publication:
**08.04.2026 Bulletin 2026/15**

(21) Application number: **25205042.2**

(22) Date of filing: **26.09.2025**

(51) International Patent Classification (IPC):
*G08B 13/12* (2006.01)       *A41D 1/04* (2006.01)
*F41H 1/02* (2006.01)        *G01L 5/00* (2006.01)
*G01N 27/24* (2006.01)

(52) Cooperative Patent Classification (CPC):
**G08B 13/12; F41H 1/02;** G01L 5/0052; G01N 27/24

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **04.10.2024 CZ 20240380**

(71) Applicant: **Ceské vysoké ucení technické v Praze 16000 Praha 6 (CZ)**

(72) Inventors:
• **Prokupek, Kristian**
  **Tursko (CZ)**
• **Mlejnek, Pavel**
  **Trebusice (CZ)**
• **Vodicka, Ales**
  **Odolena Voda (CZ)**

(74) Representative: **Poljak, Michal**
  **Nove sady 988/2**
  **602 00 Brno (CZ)**

(54) **A SENSOR FOR DETECTING PENETRATION AND A DETECTION SYSTEM COMPRISING THE SENSOR**

(57) The invention relates to a sensor (1) for detecting penetration (damage, intrusion, injury), comprising an upper insulating layer (2), a lower insulating layer (3) and at least one detection layer (4) for detecting a change in at least one component of impedance (electrical resistance and/or capacitive reactance) upon penetration of the sensor (1). Each detection layer (4) is arranged between the upper insulating layer (2) and the lower insulating layer (3) and comprises an electrical input (5) and output (6) for electrical connection to an evaluation unit (18). The detection layer (4), when viewed perpendicular to the plane of said layer, forms a single detection segment or is divided into at least two detection segments for detecting a penetration area of the sensor (1). The sensor also has an ability to detect error states.

Fig. 1

**Description**

Field of technology

This invention relates to a sensor for detecting penetration (in other words, damage, breach, intrusion, injury) of a living or non-living object and a detection system comprising said sensor. The resulting properties of the sensor and its detection capabilities can be selected by choosing the composition and design of the detection layers.

Background

In the prior art, the detection of penetration of a living or non-living object, its damage, breach or separation of its part is relatively problematic in practice. Nevertheless, there are ways in individual fields to detect and evaluate such breaches.

In the field of security (fire brigade, police, army), there are systems on the market for ballistic vests that can detect mechanical injuries, typically caused by a knife or a bullet. These systems often offer only one detection principle and can therefore detect either the extent of the damage or its location. However, both of these pieces of information together would refine the information about the damage and ensure a correct response from a supervisor.

In the field of space equipment, such as spacecraft, ships, stations, rockets, satellites, etc., monitoring the integrity of the cladding or critical components is essential for mission safety. In manned equipment, cladding integrity is monitored, for example, by atmospheric pressure loss. Furthermore, a modern problem with the operation of spacecraft in Earth's orbit is space debris, which, in large or small fragments, can damage part of the system, and this equipment is not always equipped with comprehensive damage detection that would detect even minor damage.

The international patent application WO 2009134293 A2 and related US patent applications US 2013265156 A1, US 2013265161 A1 and US 2014077949 A1 describe a flexible security film and a monitoring device that is capable of detecting and providing real-time alerts that the film has been impacted or penetrated. The signal indicating an impact on the film or penetration of the film may be based on shock, vibration, temperature or interruption of an information flow. The flexible security film can be implemented in the form of a solid plate, a foil or a printed conductive connection. The system uses an RFID transponder (RFID = radio frequency identification) as a signalling device and electronically conductive ink (e-Ink) as a means of detection. The text also mentions its use in ballistic vests and buildings as an alternative use for fire detection.

The described invention does not explain the detection patterns, detection segments or the design of the sensors themselves, which are of significant importance and where the size of the pattern or segment can determine the minimum resolution of the penetrating object. Since the system uses only one method of detection, it can be concluded that it will have shortcomings in determining the area of damage and/or the location of damage. Furthermore, the range of short-range radio frequency systems such as NFC and RFID is very small and struggles to reach tens of centimetres. In the case of UHF RFID, the range is approximately 3 metres maximum, and for low frequency RFID, it is up to 0.5 metres. The application of RFID for remote monitoring is impractical or even impossible.

The US patent US 8915118 B2 describes a sensor for detecting impact, based on a step change in capacitance when absorbing impact energy. However, it is not possible to detect penetration of the sensor, i. e. the area and extent of damage, because the capacitance value returns approximately to its original value over time. This sensor is primarily intended for measuring the absorption of impact energy or for determining the consequences of an impact on a body when an object has not penetrated the sensor or other layers. This application may be of interest in cases of assessing health damage of the impact on a protective device on a human body in a situation where there has been no penetration of the body, but only absorption of energy, e. g. by a ballistic vest.

The international patent application WO 2008054910 A2 describes a sensor for detecting penetration, based on detecting a break in a circuit comprising conductive ink (similar to WO 2009134293 A2 above), which is a part of a packaging film. A breach or complete interruption of a sensing part can be indicated by an increase in electrical resistance or a change in capacitive or inductive reactance (i. e. a component of impedance). This method of protection makes it possible to determine whether the packaging of goods has been damaged during transport but does not provide accurate information about the area and extent of the damage. In the evaluation architecture, the described invention monitors an increase in resistance as the impact of cutting a detection strip made of conductive e-ink, and the value is reflected proportionally. The disadvantage of this sensor is that the resistance value is difficult to scale and achieving good ink (conductive material) homogeneity is difficult or impossible in the long term due to the frequent presence of suspended particles (e. g. carbon particles), which also results in resistance inhomogeneity of the detection segments. In addition, the properties of conductive inks may change during printing. The use of this system requires multiplex processing (i. e. it needs many conductors).

The international patent application WO 2015164382 A1 describes a sensor for detecting projectile penetration in a ballistic vest, divided into several detection segments in front of and behind the ballistic vest for the purpose of detecting the position of sensor penetration. Vertical and horizontal conductors are routed through the detection segments, and a drop in voltage is detected when a specific circuit in the detection segment is interrupted. This invention makes it possible to detect the trajectory of the projectile or whether the protected object has been damaged. This indirect information can be used to infer the severity of the injury (location), but the system does not provide information about the area of damage. This invention primarily deals with determining the trajectory of the penetrating object, and it can be assumed that, when taking into account the spatial model of the protected object, it is possible to determine the approximate damage to the interior of the monitored object. In the case of the human body, the trajectory of the penetrating object through the body and organs can be assumed. The design of the detection segments works with coarse granularity (coarse resolution), and therefore the interpretation of injuries in space is less accurate. Furthermore, it cannot determine the size of the penetrating object.

The US patent US 6349201 B1 describes a sensor for detecting an impact on a bulletproof vest. The impact is detected based on creating a signal by a piezoelectric material. This invention can detect energy of a projectile, but its location or size of the damaged area is not detected. Upon the first penetration or damage to the detection layer (piezoceramic material), the sensor is likely to shatter, as the fragility of ceramic and piezoceramic materials is a well-known property. The anticipated disadvantage of this sensor is therefore its single-use nature and the resulting inability to detect subsequent damage.

The US patent application US 2010315226 A1 describes a general impact detection sensor without a specific detection principle. The patent focuses on the description of remote information transmission - telemetry or telemedicine using generically and longestablished technologies with microprocessors and software, as well as wireless technologies (e. g. GPS, GSM, GPRS and CDMA for data transmission). The invention does not mention methods of evaluation (measurement) of the sensor or a design of the sensor.

Among the generally known technical solutions, there is also an option of matrix connection (so-called multiplex connection). The use of multiplex measurement with a sensor having a matrix connection can be relatively accurate, and it is possible to achieve low granularity by selecting the smallest possible detection segments. However, the technical design is demanding in terms of the number of measured channels, the necessary conductive connections (or wire conductors, connectors) and the necessary integrated circuits for processing the number of signals.

In the prior art, there is a need, and the aim of the invention is to provide a robust, sensitive and inexpensive sensor for detecting penetration of a living or non-living object. The aim of the invention is to detect mechanical damage to an object using a planar sensor (or multiple sensors), whose signal is further processed by electronics, and to obtain information about the area of damage and the location of damage. The combination of these two pieces of information provides a complete overview of the extent of the damage, thereby surpassing existing inventions.

Summary of the invention

The stated objective is achieved in the first aspect of this invention by a sensor for detecting penetration, comprising an upper insulating layer, a lower insulating layer and at least one detection layer for detecting a change in at least one component of impedance upon penetration of the sensor. Each detection layer is arranged between the upper insulating layer and the lower insulating layer and comprises an electrical input and output for electrical connection to an evaluation unit. The detection layer, when viewed perpendicular to the plane of said layer, forms a single detection segment or is divided into at least two detection segments for detecting a penetration area of the sensor. The upper and lower insulating layers serve as a protective cover against corrosive or chemically or physically aggressive conditions.

The underlying idea of the sensor according to this invention is that the detection layer can detect the penetration area of the sensor. For some applications, it is not necessary to require information about the area of damage or the location of damage, which simplifies the sensor design to a more straightforward sensor design.

The sensors described below are designed to be measured using alternating, pulsating or direct current, where impedance properties are advantageously used, where impedance ($Z$) consists of an active resistance ($R$) and a reactance component ($X$), which can be inductive ($X_L$) or capacitive ($X_C$). In certain situations, impedance behaves like resistance, which is why this terminology is used throughout the document.

Impedance is defined and can be expressed, for example, as a complex number:

$$Z = R + jX$$

The sensor measurement provides values for impedance or its components. In the event of sensor penetration, the impedance or its components change in proportion to the extent of the damage.

In a first embodiment of the sensor (known as resistive sensor), the detection layer is a resistive circuit for detecting a change in electrical resistance upon penetration of the sensor. The resistive circuit comprises: a series resistor having a resistance Rs and connected in series between the electrical input and output; and at least two measuring resistors having a resistance Rn and connected in series to the series resistor, where n = 1 to k. Each measuring resistor Rn is further connected in parallel to a detection pattern formed by a conductive path, but with negligible resistance Rm, where Rm << Rn (where Rm is essentially close to zero). One detection pattern (Rm) and one measuring resistor (Rn) form one detection segment for detecting the penetration area of the sensor (based on the total area of the detection segment, which corresponds to an increase in electrical resistance by the value of resistance Rn) and/or for detecting a penetration location of the sensor (based on the location of the detection segment within the detection layer, which corresponds to an increase in electrical resistance by the value of resistance Rn).

Since the sensor may be located in a different place than the electronics (the evaluation unit), a metal connection, a printed conductive connection or conductive ink may be used to establish a conductive connection between the sensor and the electronics input. A fixed resistor, a conductive and/or vapour-deposited layer made directly on the sensor (so-called hybrid circuit technology) can be used to implement the measuring resistors Rn.

The detection pattern is advantageously a conductive line (or a conductive path) in the shape of a meander, flat pyramid, bifilar line (i. e. parallel conductors connected at the end, with opposite current flow) or a spiral (or a variously winding strip) with the smallest possible width (cross-section) to achieve optimal detection segment properties.

The detection segment can be arranged across the entire width of the detection layer, and the detection layer can comprise two or more detection segments along its entire length (e. g. in a ballistic vest to cover various organs or parts thereof). The detection segment can also be arranged so that, for example, it reflects the position of the organs of the human body when placed on/above the body. The location and size of the detection segments can be designed in various ways. The number and size of the detection segments thus define the resolution of the sensor. The resolution parameters are selected during the design of the detection segment, according to the intended application and with regard to the required granularity of the detection segment, taking into account the minimum size of the penetration test body. Since the conductive paths are interspersed with structural gaps, it is necessary that the sum of the gap dimension and the width of the conductive path of the detection segment be less than the minimum diameter of the test body.

For example, if the minimum detectable penetration object has a diameter of 3 mm, the width of the conductive path and the width of the insulating gap must together be less than this dimension.

It is advantageous to implement the resistive connection as a series-parallel circuit. An input resistor (or impedance) having a resistance Rp or impedance Zp (in the case of a parallel connection of an input resistor having a resistance Rp and an input capacitor having a capacitive reactance Cp) is connected in parallel between the electrical input and output of the detection layer, where the following conditions must be met: Rp >> ΣRn + Rs. Rp acts as the left parallel branch in the circuit, while Rs + Rn acts as the right parallel branch. In an undamaged state, the sensor has a stable minimum value given by the parallel combination Rp ∥ Rs (Rm values can be neglected). With each damaged detection segment Rm (e. g. meander), the value Rn is applied, and the resulting sensor value is higher. The resistance or impedance value of the entire sensor increases with damage.

The fixed value of Rp or Zp gives the sensor the ability to detect error states - loss of connection, short circuit on sensor, and in the case of impedance Zp, it helps to improve the behaviour of the sensor and detection system in EMC interference.

The connection of one Rn and one detection pattern forms a detection segment. Detection segments (with Rn resistors) are thus connected in series, allowing up to hundreds of detection segments to be implemented, depending on the specifics of the particular application. The number of detection segments (and thus Rn) is limited by the measurement principle used, its accuracy and resolution.

It is advantageous to have at least two measuring resistors with different resistance values Rn. These values can be, for example, values of a geometric series, whereby, after an increase in electrical resistance by the value of resistance Rn, it is possible to unambiguously determine the position of the penetrated detection segment within the detection layer, and thus also in the entire sensor (e. g. in a ballistic vest after being impacted with a bullet).

In another case, all or some of the Rn may acquire the same value, which leads to a cheaper and simpler sensor design, but in this variant, it is not possible to determine which specific detection segment has been impacted within a single sensor.

The connection of Rp, Rs and all detection segments Rn forms a single sensor.

In a second embodiment of the sensor (known as planar capacitive sensor), the detection layer is predominantly a capacitive connection comprising an intermediate insulating layer and two (preferably continuous) conductive layers for detecting a change in capacitive reactance ($X_c$) upon penetration of the sensor.

When measuring using alternating current, the capacitive reactance is given by the relationship

$$x_C = \frac{1}{2\pi f C}$$

where f denotes the operating frequency (Hz), and C denotes the capacitance of a capacitor (F).

When measuring using direct current or pulsating current, the capacitance can be measured, for example, by a transient phenomenon of an RC cell. It is also possible to convert to frequency and then measure it, for example, with a counter or a microprocessor.

The intermediate insulating layer is arranged between two detection layers, and its thickness is preferably from 1 $\mu$m to 1 mm (e. g. 0.1 mm). Both detection layers form a single detection segment for detecting the penetration area of the sensor (based on the corresponding decrease in the area of the detection segment). Both detection layers form two opposing planar capacitor electrodes, and the intermediate insulating layer forms a dielectric layer between these electrodes. The impedance is predominantly formed by capacitive reactance ($X_c$) due to the planar nature of the detection layers.

Preferably, the planar sensor also comprises a parallel-connected impedance Zp (or capacitance Cp), which defines the initial value of the entire detection segment and shifts the offset of the measured value to a better and more accurately measurable capacitance range (e. g. in the order of 1 to 1000 nF). Furthermore, owing to this Cp value, it is also possible to measure the state with 100% sensor damage. In addition, this Cp value also reduces the influence caused by the length, bend and twist of the conductor to the sensor.

The fixed value of Cp (Zp) has the advantage of enabling the detection of error states - loss of connection, short circuit on sensor.

General formula for determining sensor impedance

$$Z_{sensor} = Z_p + n * Z_{segment}$$

If a sensor with predominantly capacitive behaviour is implemented, then the following applies:

$$C_{sensor} = C_p + n * C_{segment}$$

When undamaged, the sensor provides the maximum capacity value $C_{sensor}$. With increasing damage or loss of detection segment area, the capacity value decreases proportionally to the area.

A fully planar sensor has the advantage of maximum utilisation of the sensor area. This allows it to achieve the highest yield of capacity change per area (nF/m$^2$).

However, it may not be suitable for all applications. During construction, its shape can also be defined with complex geometric shapes, cut-outs, technological openings and unmonitored areas. However, these cannot be easily divided and modified after production.

It is advantageous to create technological or functional holes or cut-outs in both detection layers, which are located above each other when viewed perpendicular to the plane of the layers and which are suitable for adapting the sensor to existing components (e. g. unmonitored components) of the object. For example, openings for mounting can be designed in this way.

In a third embodiment of the sensor (known as adaptable capacitive sensor), the detection layer is a dominant capacitive connection comprising an intermediate insulating layer between two electrically conductive layers for detecting a change (i. e. a decrease) in capacitive reactance ($X_c$) upon penetration of the sensor. The intermediate insulating layer has a thickness of preferably 1 $\mu$m to 1 mm (e. g. 0.1 mm).

Both detection layers, when viewed perpendicular to the plane of said layers, form a single detection segment. Both conductive layers thus form surface electrodes of a capacitor, and the intermediate insulating layer forms a dielectric layer between these electrodes, enabling them together to detect damage. The impedance is predominantly formed by capacitive reactance ($X_c$) due to the planar nature of the detection layers.

It is advantageous that each detection layer is a matrix of at least two planar geometric detection elements arranged such that the planar detection elements of the first detection layer are arranged above or below the planar detection elements of the second detection layer, i. e. the planar detection elements overlap when viewed from above. Furthermore, there are gaps between the detection elements, which makes it possible to cut and otherwise shape the sensor without the risk of unwanted micro-connection (short circuit) of the two conductive layers. By dividing the detection layer into planar detection elements and interconnecting them in multiple directions, it is possible to adapt the shape of the detection layer to a specific application, e. g. by cutting or bending at any time during use or installation. The size of the gap and the size of the planar detection element should be designed to correspond to the expected damage (e. g. the gap is not larger than the expected size of the penetrating body).

The conductive connection between two adjacent planar detection elements in the first detection layer is located, when viewed perpendicular to the plane of said layers, off and at a distance from the conductive connection between two adjacent planar detection elements in the second detection layer. In other words, the conductive connection between two adjacent planar detection elements in the first detection layer is not located above or below the conductive connection between two adjacent planar detection elements in the second detection layer. In other words, the conductive connections of two adjacent planar detection elements in the first and second detection layers are spatially separated and do not overlap when viewed from above, thus ensuring that they are far enough apart that they cannot connect after cutting and deformation. During cutting, there is therefore no mutual contact between the individual detection layers (or their conductive connections) via the blade of the scissors or knife, thus preventing short-circuiting of the entire sensor. The planar detection element can be any geometric shape (e. g. square, rectangle, trapezoid, parallelogram, triangle, polygon, circle or oval). The dimensions and shape of the detection elements, together with the gaps, thus determine the technical divisibility of the sensor part, the flexibility of the sensor and the shapeability of the sensor.

It is advantageous to make additional structural and auxiliary openings in these gaps for specific applications, such as attaching the sensor to protective equipment, the monitored object, etc. The function of the opening can also be for mounting or attachment, or it can modify the detection properties upon penetration. In other words, the cuts creating structural and auxiliary holes affect the degree to which the detection patterns respond to the penetrating body. It is advantageous to construct a detection segment that is more easily damaged and thus generates a greater response.

It is also advantageous to attach the sensors to the monitored object by gluing.

It is advantageous to connect at least two (ideally all) adjacent planar detection elements in each detection layer by means of a conductive connection. Such a sensor can then be divided into segments to suit the installation site.

Furthermore, the implementation of gaps and conductive connections improves the behaviour of the sensor in the event of an impact. This is achieved thanks to the different mechanical strength between the planar detection element comprising the detection pattern and the gap between the units, which comprises almost no metal part (conductive connection). This is also achieved technically by making additional auxiliary holes and cuts located in these gaps.

The measurement and evaluation of the sensor remains identical to the previous sensor type, where either the surface and/or the entire detection segment is damaged, which then reduces the resulting sensor value.

General formula for taking into account the effect of sensor damage with n detection segments:

$$C_{sensor} = C_p + \sum_n((1 - Damage_n) * Csegment_n),$$

where, for example, Damage 0.8 means that 80% of the detection segment surface is damaged.

In a fourth embodiment of the sensor, synergies of all previous sensor embodiments are used. These are arranged between the upper and lower insulating layer as follows: the first detection layer, which is the resistive embodiment described above (according to the first embodiment), an additional intermediate insulating layer, and the second detection layer, which is the capacitive embodiment described above (according to the second or third design). This sensor thus combines all the advantages of the first to third designs, i. e. it enables the detection of the area and at the same time the position of penetration of the sensor (e. g. in a ballistic vest when shot through a specific area at a specific location, similarly also in protective equipment).

In general, the insulating layer described here can be made of a polymer. In an embodiment suitable for thermally and chemically demanding environments, the insulating layer described here is made of polyimide (e. g. poly(oxydiphenylene pyromellitimide), commercially known as Kapton). However, it can also be made of polyethylene (PE), softened low-density polyethylene (LDPE), polypropylene (PP), polycarbonate (PC), polyethylene terephthalate (PET) and other plastics suitable for the production of films. Polyimide is particularly advantageous due to its flexibility, chemical and physical resistance, and low weight per unit area. More commonly used polymers (PE, LDPE, PP) are advantageous due to their low cost. The use is not limited to polymers/plastics but can also comprise environmentally friendly (biodegradable) materials such as paper and fabric. In the case of a capacitive design, the uniform permittivity of this material must be ensured.

Polycarbonate can be chosen for its excellent mechanical properties, but it has a higher production cost and rigid construction. For example, transparent machine covers, and work windows can be designed in this way, as damage to them can pose a danger to people near the machine. The material used fulfils the role of a transparent machine cover due to its toughness and is commonly used in this way.

By analogy with polycarbonate, sensors can also be placed on glass surfaces that need to be monitored.

The individual layers are advantageously bonded by gluing with a thin layer of adhesive or adhesive layer, or by pressure moulding or welding. In the following descriptions, examples and illustrations of layers, the bonding, adhesive or welding layers are not numbered.

In a preferred embodiment, the detection layer described above is made of a conductive metal used in the electrical engineering industry, using metals such as copper, silver, gold, aluminium, tin, zinc, nickel, or alloys thereof, or from a metallic or non-metallic conductive material, in particular a conductive polymer, conductive ink, conductive carbon fibres or particles. Precious metals such as copper, silver and gold are particularly advantageous for demanding applications due to their high conductivity and chemicalphysical resistance. Aluminium, nickel, zinc and alloys of these metals, on the other hand, have the advantage of being inexpensive and widely applicable. Typical manufacturing processes for producing such a sensor comprise electroplating, vapour deposition, printing or dispensing, lamination, pressing and, last but not least, cutting or etching. For high-end applications, vacuum metal deposition (e. g. physical vapour deposition (PVD) or chemical vapour deposition (CVD), or supersonic kinetic deposition) can also be considered, thereby achieving a very thin layer that still retains good conductive properties for all these designs of detection segments.

A preferred combination for high-quality and robust sensors is, for example, polyimide with a copper detection layer.

A preferred combination for cheaper, basic and less exposed applications is plastic material (polyethylene terephthalate (PET), polyethylene (PE) or polypropylene (PP)) with an aluminium detection layer.

Advantageously, the sensor of any of the above embodiments may comprise additional shielding layers (e. g. made of metal) that are grounded and arranged outside the covering insulating layers for shielding electromagnetic interference, as well as additional insulating layers arranged outside the additional shielding layers for their protection (e. g. made of the polymers mentioned above).

In a preferred embodiment for personal protection applications, the sensor described herein is incorporated into personal protective equipment ("PPE"), such as protective gear, a ballistic vest, a helmet, a coat, a glove, a shoe, a protective suit, a protective shield, etc. Specific applications comprise, for example, detection a person's protective suit (soldier, firefighter, diver, worker in a hazardous occupation or heavy industry worker) and ensuring timely assistance or remedy. Specific applications comprise, for example, detection a person's protective suit (soldier, firefighter, diver, worker in a hazardous occupation or heavy industry worker) and ensuring timely and targeted assistance in the event of penetration (e. g. based on damage to a specific organ), protecting the health of disabled and blind persons, e. g. from accidents.

In an embodiment suitable for application on objects, the sensor described here is built into work equipment, a machine visor or cover, a work tool, a space, aircraft, marine or road vehicle cladding, a battery or tank cladding, or is generally a part of an envelope of a monitored object or another monitored part of the object. The sensor thus enables immediate detection of the extent and location of damage, for example in applications such as detecting damage to an electric vehicle battery, detecting damage to satellite cladding in the event of a collision with space debris, detecting damage to a hydrogen tank, protecting goods during transport, monitoring the condition of protective covers on machines and equipment, etc.

The sensor has the advantage of being reusable even in the event of minor damage, as undamaged detection segments and/or parts thereof can provide a new baseline impedance value and be capable of detecting subsequent damage by further changes in impedance or its components.

The above object of the invention is achieved in the second aspect of this invention by a detection system comprising the above-described sensor and an evaluation unit for evaluating at least one detected component of impedance and/or total impedance, and thereby for evaluating a change in at least one component of impedance upon penetration of the above-mentioned sensor.

The evaluation unit comprises 1 to N input channels for connecting 1 to N sensors. Each input channel of the evaluation unit is electrically connected to the electrical input and output of each detection layer by means of conductors (e. g. fixed soldered, welded or pressed connections, implemented in a cable harness) or by means of a connector (e. g. detachable). Thanks to the small number of connections (2 to 4 wires), the sensor according to the invention does not require extensive circuits according to the current prior art (multiplexers, complicated wiring, multi-pin connectors).

The evaluation unit is advantageously equipped with an electronic block that evaluates changes in impedance or its components (this can be implemented, for example, by a converter of impedance and/or components of impedance to an analogue and/or frequency and/or digital signal). Furthermore, the evaluation unit comprises a microprocessor for signal evaluation, calculations and algorithms. It is also equipped with a communication interface for communication with external devices (e. g. signalling and/or monitoring and/or telemetry devices).

The local signalling output of the evaluation unit can be a display. This can be graphic or alphanumeric. The display can be selected from the display technologies available on the market (e. g. liquid crystal display (LCD), optionally with a thin film transistor (TFT) technology, (organic) light-emitting diodes (OLED, LED), or electronic ink displays (e-Ink or e-Paper).

Advantageously, this signalling device displays information about the sensor status (status unchanged/status changed) and the extent of damage (e. g. in percentages from 0 to 100% or in user units or classifications corresponding to the severity of damage and/or integrity).

The evaluation unit is preferably implemented as low power, allowing operation from mobile power sources such as batteries, accumulators, photovoltaics, and piezoelectric power generators. This also allows for use on mobile objects.

It can also be powered from fixed distribution systems for permanent installations.

The evaluation unit is advantageously connected to multiple sensors via 1 to N input channels, allowing it to scan a larger area and thus enabling group monitoring.

The detection system also comprises a remote signalling device that is connected by wire or wirelessly to at least one evaluation unit (or its communication module) to signal a change in integrity and/or damage when the sensor is penetrated and/or in user units representing these states. The remote signalling device may be a display, mobile phone, tablet, laptop, computer, surveillance system, central desk, mobile surveillance system, on-board system, system for remote control and monitoring of operations, or a more complex PLC or SCADA system in the case of fixed operational installations.

The communication module of the evaluation unit and remote signalling device can operate using generic communication technologies and protocols such as Wi-Fi, Bluetooth, Bluetooth LE, Ant, ZigBee, LoRA, GSM, GPRS, LTE, 5G, SigFox, RFID or NFC. Furthermore, in the case of stationary monitored objects, network connections in the form of Ethernet, USB, RS-232, RS-485, HART, M-Bus, CAN, CAN 2.0, CAN FD, Lin-Bus, Profi-Bus, Profi-NET, KNX, ASCII, Modbus, TCP/IP with TCP or UDP, including other layers of the OSI model, are also possible. This does not exclude the use of a proprietary communication protocol.

Brief description of the drawings

Figure 1 schematically shows a first embodiment of the sensor (resistive) according to the invention in a perspective view.

Figure 2 shows an internal wiring of the first embodiment of the sensor (resistive).

Figure 3 schematically shows a second and third embodiment of the sensor (capacitive planar and capacitive adaptable) according to the invention in a perspective view.

Figure 4 schematically shows the third embodiment of the sensor (capacitive adaptable) according to the invention in a top view.

Figure 5 shows an internal wiring of the second and third embodiments of the sensor (capacitive).

Figure 6 shows an internal wiring of the second and third embodiments of the sensor (capacitive) with an output capacitor.

Figure 7 schematically shows a fourth embodiment of the sensor (combined) according to the invention in a perspective view.

Figure 8 schematically shows a detection system according to the invention.

Examples

**Example 1 "resistive sensor"**

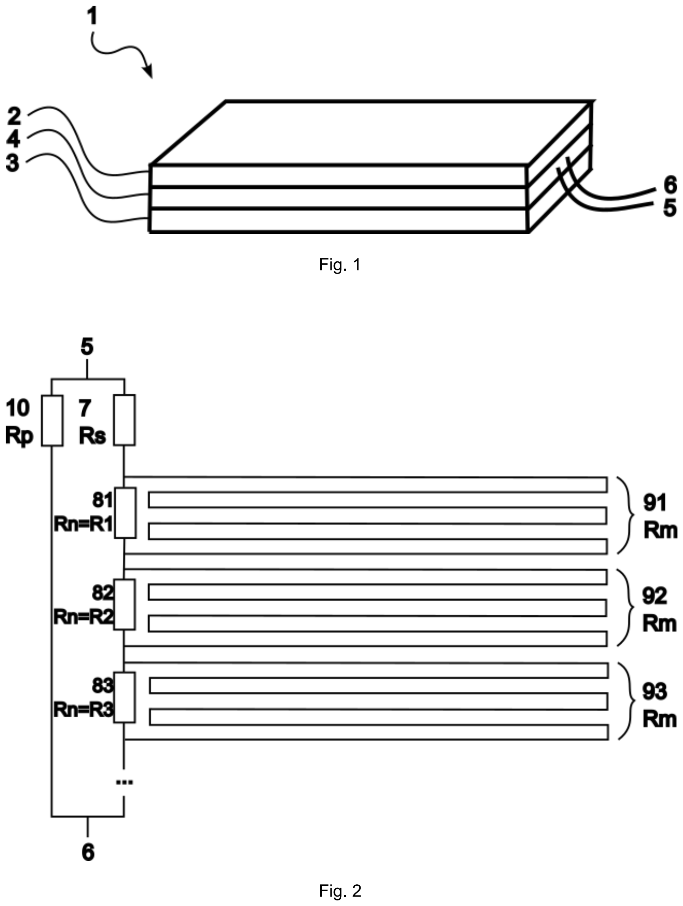

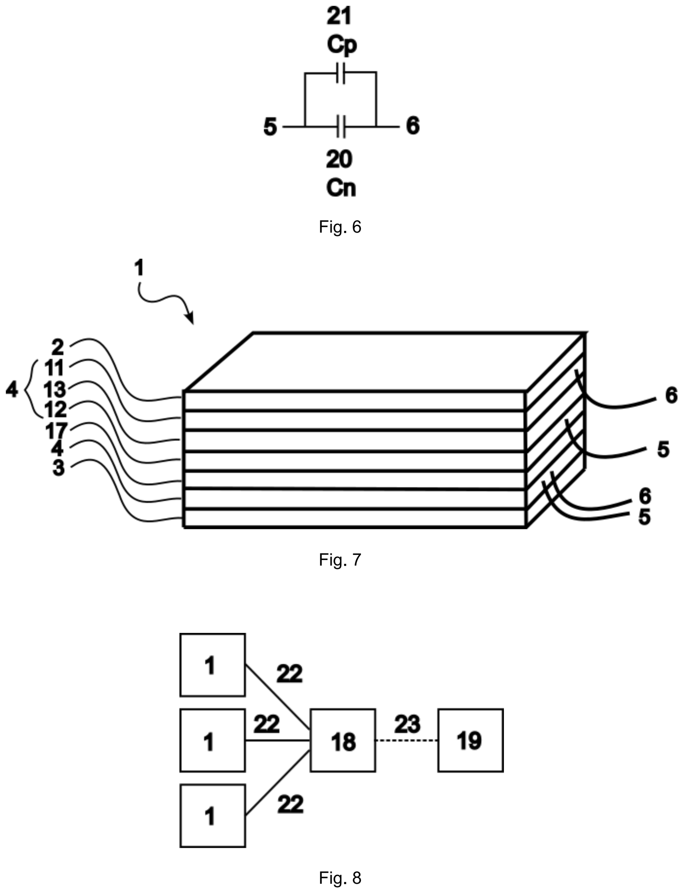

Fig. 1 shows a three-layer sensor 1 for detecting penetration by means of a change in impedance or electrical resistance, comprising an upper insulating layer 2, a lower insulating layer 3 and a detection layer 4, which is a resistive circuit for detecting a change in electrical resistance upon penetration of the sensor 1. The detection layer 4 is arranged between the upper insulating layer 2 and the lower insulating layer 3 and comprises an electrical input 5 and output 6 for electrical connection to an evaluation unit 18 (see Example 5 and Fig. 8). The detection layer 4 is divided into several detection segments for detecting the area and position of penetration of the sensor 1.

The resistive circuit in Fig. 2 comprises a series resistor 7 having a resistance $Rs$ and connected in series between the electrical input 5 and output 6 and a plurality of measuring resistors $81$ to $8n$ having a resistance $Rn$, where $n = 1$ to $k$. The resistance values $Rn$ of the individual measuring resistors $81$ to $8n$ may be the same or different. Each measuring resistor $81$ to $8n$ is further connected in parallel with a detection pattern $91$ to $9n$ having a resistance $Rm$, where $Rm \ll Rn$ and where $Rm$ is essentially close to zero and negligible. An input resistor 10 having a resistance $Rp$, where $Rp \gg Rn$, is also connected in parallel between electrical input 5 and output 6 to signal the connection of the detection layer 4.

One detection pattern $91$ to $9n$ forms one detection segment for detecting a penetration area of the sensor 1 (based on the total area of the given detection segment, which corresponds to an increase in electrical resistance by the value of resistance $Rn$) and/or for detecting the position of penetration of sensor 1 (based on the location of the given detection segment within the detection layer 4, which corresponds to an increase in electrical resistance by the value of resistance $Rn$). The sensor circuit $91$ to $9n$ is a meander-shaped conductor of a defined width, i. e. with a length several times greater than that of the remaining parallel branch with measuring resistors $81$ to $8n$. The sensor circuit $91$ to $9n$ is arranged across the entire width of the detection layer 4.

In an undamaged (integral) sensor, the resistance Rm of the detection pattern 91 to 9n is significantly lower than the resistance Rn of the corresponding measuring resistor 81 to 8n, so that the branch with the measuring resistor 81 to 8n is essentially short-circuited by the low value of Rm, and the resistances Rn do not affect the resulting value of electrical resistance (and total impedance). As a result of penetration of the sensor 1, at least one detection pattern 91 to 9n is broken, in which case the resistance Rn is applied in the resulting value of electrical resistance (and total impedance). If the resistance values are arranged in a geometric series, after an increase in electrical resistance by the value of resistance Rn, the position of the penetrated detection segment within the detection layer 4, i. e. within the entire sensor, can be clearly determined.

The difference between the initial value of the sensor, which is stored in the memory of the evaluation device at the time of manufacture or installation of the sensor, and its difference with the new value, which already comprises the detected damage, is essential for evaluation.

Example of possible Rn values in a geometric series: 10, 22, 47, 100, 220.

Here, the design condition is that the sum of any smaller Rn values is not equal to the current assessed Rn value in order to prevent misinterpretation, where several damaged segments will behave similarly to the currently assessed Rn segment in the measured value. The accuracy of the measurement must also be taken into account during the assessment.

Example of Rn values in a homogeneous series: 22, 22, 22, 22, 22.

**Example 2 "planar capacitive sensor"**

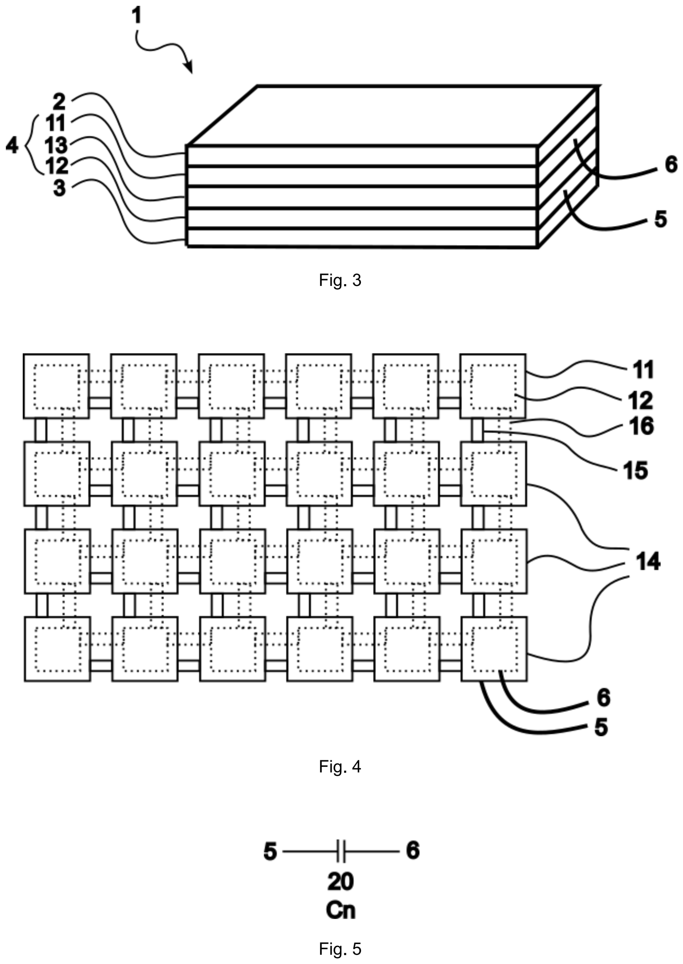

Fig. 3 shows a five-layer sensor 1 for detecting penetration by means of a change in impedance or a change in capacitive reactance, comprising an upper insulating layer 2, a lower insulating layer 3 and a detection layer 4, which is a capacitive circuit for detecting a change in capacitive reactance upon penetration of the sensor 1. The detection layer 4 is arranged between the upper insulating layer 2 and the lower insulating layer 3 and comprises an electrical input 5 and output 6 for electrical connection to an evaluation unit 18 (see Example 5 and Fig. 8). The detection layer 4 forms a single detection segment for detecting a penetration area of the sensor 1.

The capacitive connection in Figs. 3 and 4 comprises an intermediate insulating layer 13 and two conductive layers 11, 12 for detecting changes in capacitive reactance upon penetration of the sensor 1. The intermediate insulating layer 13 is arranged between the two conductive layers 11, 12, and its thickness is from 1 $\mu$m to 1 mm (e. g. 0.1 mm). Both conductive layers 11, 12 form a single detection segment for detecting the size of the penetration area of the sensor 1 based on the corresponding decrease in the area of the detection segment and the decrease in the capacitive reactance value. Both conductive layers 11, 12 thus form the surface electrodes of the measuring capacitor 20 in Fig. 5, and the intermediate insulating layer 13 forms the dielectric layer between these electrodes. Holes or geometric cut-outs for unmonitored components of the object (not shown in Fig. 4) can be created in both conductive layers 11, 12, which are located above each other when viewed perpendicular to the plane of the layers.

In parallel with a measuring capacitor 20 with a capacity of Cn, an output capacitor 21 with a capacity of Cp (see Fig. 6) can also be connected, which defines the offset-shifted zero value of the entire segment to obtain well-measurable impedance values (impedance or capacitive reactance). This also ensures the possibility of detecting 100% damage and eliminating noise.

For example, a sensor with an area of S = 600 cm$^2$ has a design and initial sensor capacity $C_{sensor}$ = 80 nF. The sensor also comprises a capacitor Cp = 22 nF, which contributes to the total value of $C_{sensor}$. The capacity Cn of the sensor is then 58 nF. After dividing by the usable area S, the nominal capacitance is 0.097 nF/cm$^2$.

If the sensor is damaged, causing the value to drop from 80 nF to 77 nF, for example, the difference between the current value and the initial value of the sensor capacity (80 - 77) = 3 nF, which corresponds proportionally to the damaged area of the sensor. The damaged area can also be calculated using the known nominal value (0.097 nF/cm$^2$), where the calculated damage corresponds to an area of Sx = 31.03 cm$^2$.

The monitored object is therefore damaged by

$$P = (Sx / S) * 100\% = (31.03 / 600) * 100\% = 5.17\%$$

**Example 3 "adaptable capacitive sensor"**

The sensor in example 3 is analogous to the sensor in example 2, except for the differences listed below. Both conductive layers 11, 12 form a single detection segment for detecting the size of the penetration area of the sensor 1 based on the corresponding decrease in the area of the detection segment and the decrease in the capacitive reactance value.

Each conductive layer 11, 12 in Fig. 4 is a matrix of several planar detection elements 14 (e. g., squares, rectangles) arranged such that the planar detection elements 14 of the first conductive layer 11 are arranged above or below the planar detection elements 14 of the second conductive layer 12, thereby achieving the cuttability of the conductive layers 11, 12 between the individual planar detection elements 14. The conductive connection 15 of two adjacent planar detection elements 14 in the first conductive layer 11 is not located above or below the conductive connection 16 of two adjacent planar detection elements 14 in the second conductive layer 12. During cutting, there is therefore no mutual contact between the individual conductive layers 11, 12 (or their conductive connections) via the blade of the scissors or knife, thus preventing short-circuiting of the entire sensor 1. Each two adjacent planar detection elements 14 in each conductive layer 11, 12 are connected by the conductive connections 15, 16.

**Example 4 "combined sensor"**

Fig. 7 shows a sensor 1 for complex penetration detection, comprising an upper insulating layer 2 and a lower insulating layer 3, and between the upper and lower insulating layers 2, 3, the following are arranged on top of each other: a first detection layer 4, which is the resistive circuit described above (according to Example 1), an additional intermediate insulating layer 17, and a second detection layer 4, which is the capacitive circuit described above (according to Example 2 or 3). In all embodiments, the sensor can be adapted by bending.
This sensor is manufactured by assembling all layers at once. A sensor comprising two separate sensors according to Fig. 1 and Fig. 3 (or according to Examples 1 and 2, or 1 and 3), connected to each other, for example, by an adhesive layer, has an identical function.
Comprehensive penetration detection is the ability to detect both the size and location of a penetration.

**Example 5**

The sensor according to Example 5 is analogous to the sensor according to any of Examples 1 to 4, except for the differences listed below.
The sensor 1 comprises additional shielding layers (e. g. made of metal) that improve resistance to electromagnetic interference and thus improve the detection properties of the sensor in areas where such interference may be undesirable. The layers are connected to the ground or working ground of the electronics and arranged outside the covering insulating layers 2, 3 for shielding electromagnetic interference (not shown in the figures). The sensor 1 further comprises additional insulating layers arranged outside the additional shielding layers for their protection (e. g., made of the polymers mentioned here, not shown in the figures).
In the embodiment according to Example 1, these additional layers increase the sensor composition to seven layers.
If we apply additional layers in both capacitive designs according to Examples 2 and 3, these additional layers increase the sensor composition to nine layers.
If we apply additional layers to the combined sensor according to Example 4, these additional layers increase the sensor composition to 11 layers.

**Example 6 "detection system"**

Fig. 8 shows a detection system comprising one or more sensors 1 (according to Examples 1 to 5), whose detection layer 4 is electrically connected via an electrical input 5 and output 6 and connecting wires 22 to an evaluation unit 18 for measuring (and evaluation) of changes in at least one component of impedance upon penetration of the sensor 1. The evaluation unit 18 is further connected by a wired or wireless communication link 23 to a remote signalling device 19 for signalling changes in at least one component of impedance upon penetration of the sensor 1. The communication link can be selected according to the specific needs of the application and the monitored object, for example, one of the above-mentioned generic wireless technologies can be used for a moving object.

Industrial applicability

The sensor and detection system described above can be used to protect living objects - people and animals, e. g. in protective gear, a ballistic vest, a helmet, a coat, a glove, a shoe, a protective suit, a spacesuit, a diving suit, an assistance dog, a service animal, etc.
Furthermore, the sensors described above can be used to protect inanimate objects, such as a space, aircraft, marine or road vehicle cladding, a battery or tank cladding (e. g. lithium car batteries, domestic lithium storage), a work tool, a machine part, a visor, pressure cylinder protection, packaging and protection of shipments during transport.

List of reference signs

| | |
|---|---|
| 1 | sensor |
| 2 | upper insulating layer |
| 3 | lower insulating layer |
| 4 | detection layer |
| 5 | electrical input |
| 6 | electrical output |
| 7 | series resistor |
| 10 | input resistor |
| 11 | first conductive layer |
| 12 | second conductive layer |
| 13 | intermediate insulating layer |
| 14 | planar detection element |
| 15 | conductive connection in the first conductive layer 11 |
| 16 | conductive connection in the second conductive layer 12 |
| 17 | additional intermediate insulating layer |
| 18 | evaluation unit |
| 19 | remote signalling device |
| 20 | measuring capacitor |
| 21 | output capacitor |
| 22 | connecting wire |
| 23 | communication connection |
| 8n | measuring resistor (81, 82, ...) |
| 9n | detection pattern (91, 92, ...) |

**Claims**

**1.** A sensor (1) for detecting penetration, comprising an upper insulating layer (2) and a lower insulating layer (3), **characterised in that** it further comprises at least one detection layer (4) for detecting a change in at least one component of impedance upon penetration of the sensor (1), wherein each detection layer (4) is arranged between the upper insulating layer (2) and the lower insulating layer (3) and comprises an electrical input (5) and output (6) for electrical connection to an evaluation unit (18), wherein the detection layer (4), when viewed perpendicular to the plane of said layer, forms a single detection segment or is divided into at least two detection segments for detecting a penetration area of the sensor (1).

**2.** The sensor (1) according to claim 1, **characterised in that** the detection layer (4) is a capacitive circuit comprising an intermediate insulating layer (13) and two conductive layers (11, 12) for detecting a change in capacitive reactance upon penetration of the sensor (1), wherein the intermediate insulating layer (13) is arranged between the two conductive layers (11, 12), wherein both conductive layers (11, 12) form one detection segment for detecting the penetration area of the sensor (1), wherein each conductive layer (11, 12) is divided, when viewed perpendicular to the plane of said layers, into at least two mutually conductively connected planar detection elements (14).

**3.** The sensor (1) according to claim 2, **characterised in that** each conductive layer (11, 12) is a matrix of at least two planar detection elements (14) arranged such that the planar detection elements (14) of the first conductive layer (11) are arranged above or below the planar detection elements (14) of the second conductive layer (12), wherein a conductive connection (15) of two adjacent planar detection elements (14) in the first conductive layer (11) is located, when viewed perpendicular to the plane of said layers, off and at a distance from a conductive connection (16) of two adjacent planar detection elements (14) in the second conductive layer (12).

**4.** The sensor according to claim 3, **characterised in that** an opening is located in a gap between two planar detection elements (14) of each conductive layer (11, 12).

**5.** The sensor (1) according to claim 1, **characterised in that** the detection layer (4) is a resistive circuit for detecting a change in electrical resistance upon penetration of the sensor (1), wherein the resistive circuit comprises: a series resistor (7) having a resistance Rs and connected in series between the electrical input (5) and output (6); and at least two measuring resistors (8n) having a resistance Rn, where n = 1 to k; wherein a detection pattern (9n) having a resistance Rm is further connected in parallel with each measuring resistor (8n), where Rm << Rn, wherein one detection pattern (9n) and one measuring resistor (8n) form one detection segment for detecting the penetration area and/or a penetration location of the sensor (1).

6. The sensor (1) according to claim 5, **characterised in that** the detection pattern (9n) is a conductive line in the shape of a meander, a flat pyramid, a bifilar line or a spiral.

7. The sensor (1) according to claim 5 or 6, **characterised in that** the resistive circuit further comprises an input resistor (10) having a resistance Rp and connected in parallel between the electrical input (5) and output (6), where Rp > ($\Sigma$Rn + Rs).

8. The sensor (1) according to any of claims 5 to 7, **characterised in that** at least two measuring resistors (8n) have different or equal resistance values Rn.

9. The sensor (1) according to claim 1, **characterised in that** the detection layer (4) is a capacitive circuit comprising an intermediate insulating layer (13) and two conductive layers (11, 12) for detecting a change in capacitive reactance upon penetration of the sensor (1), wherein the intermediate insulating layer (13) is arranged between the two conductive layers (11, 12), wherein both conductive layers (11, 12) form a single detection segment for detecting the penetration area of the sensor (1).

10. The sensor (1) according to claim 9, **characterised in that** holes or cut-outs are formed in both conductive layers (11, 12), which holes or cut-outs are located above each other when viewed perpendicular to the plane of said layers.

11. The sensor (1) according to any of the preceding claims, **characterised in that** a first detection layer (4), which is the resistive circuit according to any of claims 5 to 8; an additional intermediate insulating layer (17); and a second detection layer (4), which is the capacitive circuit according to any of claims 2 to 4 or 9 to 10, are arranged on top of each other between the upper and lower insulating layers (2, 3).

12. The sensor (1) according to any of the preceding claims, **characterised in that** the insulating layer (2, 3, 13, 17) is made of a polymer, in particular polyimide, polyethylene, low-density polyethylene, polypropylene, polycarbonate or polyethylene terephthalate, or furthermore of paper or a biodegradable fabric.

13. The sensor (1) according to any of the preceding claims, **characterised in that** the detection and/or conductive layer (4, 11, 12) is made of metal, in particular copper, silver, gold, aluminium, tin, zinc or nickel, or alloys thereof, or of a metallic or non-metallic conductive material, in particular a conductive polymer, conductive ink, conductive carbon fibres or particles.

14. The sensor (1) according to any of the preceding claims, **characterised in that** it is incorporated into protective work equipment, protective gear, a ballistic vest, a helmet, a coat, a glove, a shoe, a protective suit, a protective shield, a spacesuit, a diving suit, work equipment, a machine visor or cover, a work tool, a space, aircraft, marine or road vehicle cladding, a battery or tank cladding, or a part of an envelope of a monitored object.

15. A detection system comprising the sensor (1) according to any of the preceding claims, **characterised in that** it further comprises an evaluation unit (18) for evaluating at least one detected component of impedance and/or total impedance, and thereby for evaluating a change in at least one component of impedance upon penetration of the sensor (1), wherein the evaluation unit (18) is electrically connected to the electrical input (5) and output (6) of each detection and/or conductive layer (4, 11, 12) by means of conductors or a connector, wherein the detection system optionally further comprises a remote signalling device (19) which is connected by wire or wirelessly to one or more evaluation units (18) for signalling a change in integrity or damage upon penetration of the sensor (1).

Fig. 1

Fig. 2

Fig. 3

Fig. 4

Fig. 5

21
Cp

5 ———| 6

20
Cn

Fig. 6

1

2
11
4 { 13
12
17
4
3

6

5

6
5

Fig. 7

1
22
1
22
18
23
19
1
22

Fig. 8

Europäisches
Patentamt
European
Patent Office
Office européen
des brevets

# EUROPEAN SEARCH REPORT

**Application Number**

EP 25 20 5042

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/188078 A1 (SOLES ALEXANDER M [US] ET AL) 26 July 2012 (2012-07-26) | 1,12-15 | INV. G08B13/12 |
| Y | * 67-102,105-129; Figs. 1-3,5-6C,8-18; Cls. 1,12-14,20-24 * | 1,2,5-9, 11 | A41D1/04 F41H1/02 |
| A | | 3,4 | |
| | ----- | | ADD. |
| X | WO 2024/003362 A1 (SAINT GOBAIN CT RECHERCHES [FR]) 4 January 2024 (2024-01-04) | 1,9,10, 12-14 | G01L5/00 G01N27/24 |
| Y | * page 13 - page 21; figures 2,4A-4F * | 1,2,9,10 | |
| A | | 3,4 | |
| | ----- | | |
| Y | US 2019/392689 A1 (SCHWARZ KARL-ALFRED [DE]) 26 December 2019 (2019-12-26) | 1,2,5-11 | |
| A | * 5-7, 14-17,21,28-34,41,47,54-59; Figs. 1-5D * | 3,4 | |
| | ----- | | |
| A | US 2019/371161 A1 (BRINKLEY KENNETH [US] ET AL) 5 December 2019 (2019-12-05) * 60,65,67,68,91-93; Figs. 1 4A-5A,10 * | 1,5,10 | |
| | ----- | | |

**TECHNICAL FIELDS SEARCHED (IPC)**

G08B
G01L
F41A
F41H
G01N

The present search report has been drawn up for all claims

| Place of search | Date of completion of the search | Examiner |
|---|---|---|
| Munich | 18 February 2026 | Hausinger, Johannes |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 20 5042

This annex lists the patent family members relating to the patent documents cited in the above-mentioned European search report.
The members are as contained in the European Patent Office EDP file on
The European Patent Office is in no way liable for these particulars which are merely given for the purpose of information.

18-02-2026

| Patent document cited in search report | Publication date | Patent family member(s) | Publication date |
|---|---|---|---|
| US 2012188078 A1 | 26-07-2012 | US 2012188078 A1 | 26-07-2012 |
| | | US 2012191373 A1 | 26-07-2012 |
| | | US 2012191374 A1 | 26-07-2012 |
| | | US 2012191375 A1 | 26-07-2012 |
| | | US 2012191376 A1 | 26-07-2012 |
| | | US 2014172245 A1 | 19-06-2014 |
| | | US 2015114122 A1 | 30-04-2015 |
| | | US 2016005241 A1 | 07-01-2016 |
| WO 2024003362 A1 | 04-01-2024 | EP 4548036 A1 | 07-05-2025 |
| | | FR 3137444 A1 | 05-01-2024 |
| | | WO 2024003362 A1 | 04-01-2024 |
| US 2019392689 A1 | 26-12-2019 | CA 3043262 A1 | 31-05-2018 |
| | | DE 102016122923 A1 | 30-05-2018 |
| | | DE 112017006007 A5 | 20-02-2020 |
| | | EP 3520090 A1 | 07-08-2019 |
| | | US 2019392689 A1 | 26-12-2019 |
| | | WO 2018095487 A1 | 31-05-2018 |
| US 2019371161 A1 | 05-12-2019 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009134293 A2
- US 2013265156 A1
- US 2013265161 A1
- US 2014077949 A1
- US 8915118 B2
- WO 2008054910 A2
- WO 2015164382 A1
- US 6349201 B1
- US 2010315226 A1